# EUROPEAN PATENT SPECIFICATION

(11) **EP 3 576 161 B1**
(45) Date of publication and mention of the grant of the patent: **05.05.2021**
(21) Application number: 18461561.5
(22) Date of filing: 30.05.2018
(51) Int. Cl.: H01L 31/0352, H01L 31/0468, H01L 31/0392

(54) **A NON-SILICON PHOTOVOLTAIC CELL, A CONSTRUCTION ELEMENT AND A METHOD FOR MANUFACTURING NON-SILICON PHOTOVOLTAIC CELLS**
SILICIUMFREIE FOTOVOLTAIKZELLE, KONSTRUKTIONSELEMENT UND VERFAHREN ZUR HERSTELLUNG VON SILICIUMFREIEN FOTOVOLTAIKZELLEN
CELLULE PHOTOVOLTAÏQUE SANS SILICIUM, ÉLÉMENT DE CONSTRUCTION ET PROCÉDÉ DE FABRICATION DE CELLULES PHOTOVOLTAÏQUES SANS SILICIUM

(43) Date of publication of application: 04.12.2019
(73) Proprietor: Centrum Badan i Rozwoju Technologii dla Przemyslu S.A., 00-645 Warszawa (PL)
(72) Inventor: Putynkowski, Grzegorz, 00-193 Warszawa (PL); Andrysiewicz, Wojciech, 30-347 Krakow (PL); Panek, Piotr, 34-120 Andrychow (PL); Socha, Robert, 32-091 Michalowice (PL); Sobkow, Jacek, 68-120 Ilowa (PL); Bartmanski, Marcin, 00-745 Warszawa (PL); Leszczynska, Karolina, 06-100 Pultusk (PL)
(74) Representative: Kancelaria Eupatent.pl Sp. z.o.o

(56) References cited:
- US-A1- 2010 193 768
- US-A1- 2016 043 253
- US-B1- 6 441 297

## Description

The invention relates to a non-silicon photovoltaic cell, a construction element and a method of manufacturing non-silicon photovoltaic cells.

A photovoltaic cell is a semi-conductive device that converts solar radiation into electric energy as a result of photoelectric effect. Usually, photovoltaic cells have one active surface (that takes part in energy conversion) and are made on a basis of silicon wafers. Photovoltaic cells are connected with each other into modules to form photovoltaic panels.

There are also known double-sided photovoltaic cells, having two active surfaces, which are characterized by a higher efficiency per occupied area and a higher ratio of manufacturing costs to performance. Correctly installed double-sided panels allow simultaneous conversion of directly incident sunlight (e.g. incident on the top surface) as well as reflected sunlight incident on the underside (reflected from another reflective surface upon which the panel is mounted).

It would be desirable to develop an alternative structure of a photovoltaic cell, along with a manufacturing method that would allow to reduce the energy consumption of the manufacturing process and the amount of materials used therein, to consequently reduce the manufacturing costs

US2016043253 A1 discloses a photovoltaic cell comprising a baseplate having protrusions with a p-type layer, an n-type layer, and a transparent layer deposited on the protrusions.

The object of the invention is a photovoltaic cell comprising a baseplate with a coating, having a perforated active area located on both sides of the baseplate and an electric contact area located on at least one edge of the baseplate, the solar cell being characterized in that, on the active area there are located successively the following layers arranged on each other: a p-type layer having a thickness from 100nm to 2000 µm; an n-type layer having a thickness from 100nm to 2000µm, made of magnesium oxide (II) doped zinc oxide (II) (ZnO:MgO); a transparent layer made of aluminum doped zinc oxide (II), that forms a transparent electric contact; a metallic electric contacts layer; wherein the layers disposed on the opposite sides of the baseplate are connected together via perforation openings.

Preferably, the baseplate is made entirely of copper.

Preferably, the baseplate is made entirely of aluminum.

Preferably, the n-type layer is made of zinc oxide (II) having a thickness from 100nm to 2000nm and has a form of nano-rods, wherein empty spaces between the nano-rods are filled with a magnesium oxide (II) doped zinc oxide (II) (ZnO:MgO) structure.

Preferably, the n-type layer is made of zinc oxide (II) having a thickness from 100nm to 2000nm and has a form of nano-rods, wherein empty spaces between the nano-rods are filled with a zinc oxide (II) structure.

Preferably, the perforation openings have a diameter from 0.02mm to 2mm.

Preferably, the perforation openings have a shape selected from the group comprising a cylindrical, elliptic, oval, elongated, polygonal, irregular shape.

Preferably, the perforation openings are distanced from each other by a distance from 0.02mm to 2mm.

Preferably, the perforation openings are distributed in a pattern selected from the group comprising a square pattern, a staggered pattern, a diagonal pattern, a z-staggered pattern, a periodically changing pattern, an irregular pattern.

Preferably, the p-type layer is located in the entire volume of the perforation openings and the other layers located on the opposite sides of the baseplate are not connected with each other.

Preferably, the baseplate coating is a copper coating.

Preferably, the baseplate coating is an aluminum coating.

Preferably, the p-type layer is a layer of copper oxide (I) or copper oxide (II).

Preferably, the p-type layer is a layer of tin sulfide.

Preferably, the empty spaces inside the perforation openings are filled with a light-scattering medium.

Preferably, the solar cell is coupled with a reflecting, light scattering surface.

Another object of the invention is a construction element characterized in that the photovoltaic cell as described above in a form of a foil is applied on a surface of the construction element.

Preferably, the photovoltaic cell is integrated with the surface of the construction element.

Another object of the invention is a method of manufacturing of a photovoltaic cell as described above, characterized in that it comprises the following steps: preparing a baseplate having a perforated active area; applying a p-type layer onto the active area of the baseplate using an ALD method (Atomic Layer Deposition); applying an n-type layer onto the p-type layer using an ALD method (Atomic Layer Deposition); applying a transparent layer of zinc oxide (II) doped with aluminum onto the n-type layer using an ALD method (Atomic Layer Deposition); and printing metallic electric contacts on the transparent layer by screen printing using low-temperature heating up to 300°C.

Preferably, the p-type layer is applied by a PECVD method (Plasma-Enhanced Chemical Vapor Deposition).

Preferably, the p-type layer is applied by a thermal method using a heated chamber in an oxygen atmosphere.

Preferably, the p-type layer is applied by an electrolytic oxidation method.

Preferably, the n-type layer is applied by a PECVD method (Plasma-Enhanced Chemical Vapor Deposition).

Preferably, the metallic electric contacts are printed by stencil printing.

Preferably, the metallic electric contacts are printed by ink-jet printing.

The following invention is presented by means of example embodiments on a drawing, wherein:
Fig. 1 presents a first embodiment of a non-silicon photovoltaic cell in a top view and in cross-sections A-A, B-B and C-C;
Fig. 2 presents particular variants of the first embodiment of the photovoltaic cell;
Fig. 3 presents a first variant of a second embodiment of a non-silicon photovoltaic cell in a top view and in cross-sections D-D, E-E and F-F;
Fig. 4 presents particular variants of the second embodiment of the photovoltaic cell;
Fig. 5 presents an example of geometrical patterns of a perforation;
Fig. 6 presents an example of the photovoltaic cell applied onto an irregular surface of a roof tile;
Fig. 7 presents a roof tile of Fig. 6 in a side view and details of A, B and C areas;
Fig. 8 presents steps of a method of manufacturing a photovoltaic cell.

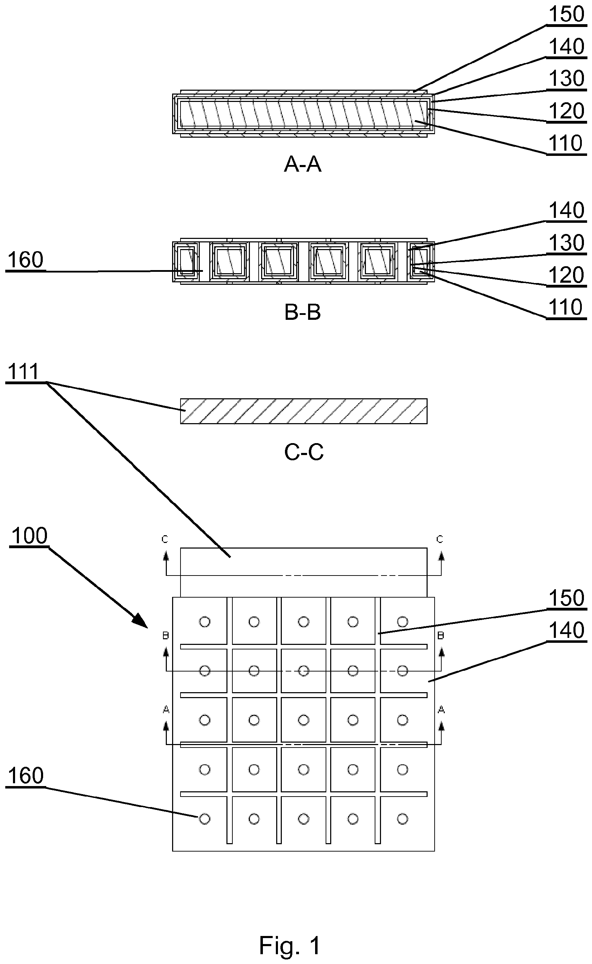

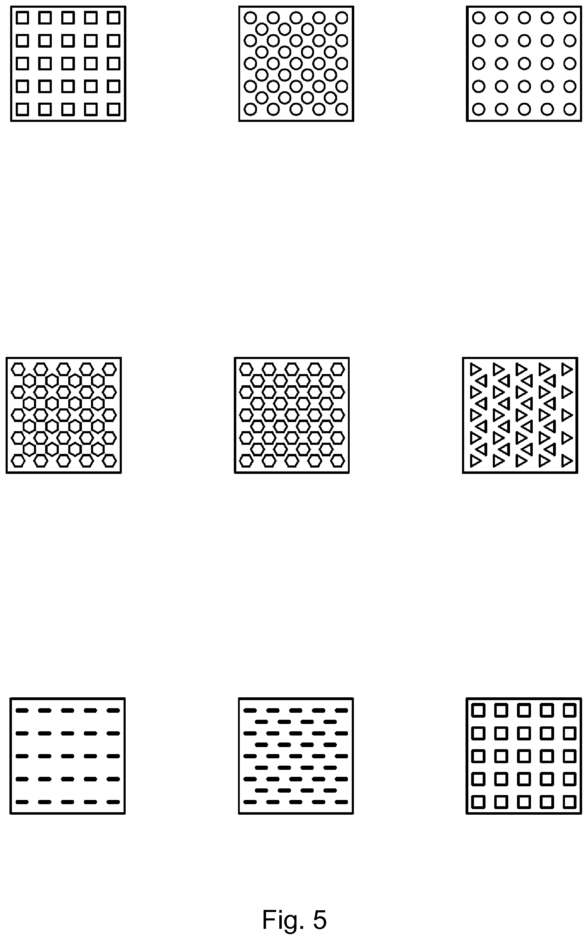

Fig. 1 presents a first embodiment of a non-silicon photovoltaic cell in a top view and cross-sections A-A, B-B and C-C. The photovoltaic cell 100 consists of a baseplate 110 which acts as a positive electrode, wherein the baseplate 110 is coated with a copper or an aluminum layer or is entirely made of copper or aluminum. Preferably, the baseplate 110 has a thickness from 0.02mm to 2mm. The baseplate comprises an area of an ohmic base electric contact 111 and on the remaining surface, an active area coated with a multi-layer semiconductor structure, which acts as a p-n junction, or two p-n junctions having a common p-type element. An active area is located on both sides of the baseplate 110 and it is perforated, wherein perforation openings 160 have a diameter from 0.02mm to 2mm and can have a cylindrical, elliptical, oval, elongated, polygonal or irregular cross-section. The openings 160 can be filled with a transparent light-scattering medium having a thickness from 0.02mm to 2mm. The distance between the perforation openings 160 is from 0.02mm to 2mm, wherein the openings 160 can be distributed in a pattern selected from the group consisting of: a square pattern, a staggered pattern, a diagonal pattern, a z-staggered pattern, a periodically changing pattern or an irregular pattern. Examples of the geometrical patterns of the perforation are shown in Fig. 5.

If the baseplate is made of copper, then the baseplate 110 is coated, in the region of the active area, with a p-type layer 120 of copper oxide (II) CuO or copper oxide (I) Cu₂O having a thickness from 100nm to 2000 µm. If the baseplate is made of aluminum, it is coated with a p-type layer 120 of tin sulfide SnS having a thickness from 100nm to 2000µm. The p-type layer 120 on the baseplate made of copper can be manufactured using an ALD method (Atomic Layer Deposition), a PECVD method (Plasma-enhanced Chemical Vapour Deposition), a thermal method using heated chamber in an oxygen atmosphere or by oxidation. The p-type layer 120 on the baseplate made of aluminum can be manufactured using an ALD method (Atomic Layer Deposition), a PECVD method (Plasma-enhanced Chemical Vapour Deposition), a hydrothermal method, a CBD method (Chemical Bath Deposition) or an electrolytic method.

The p-type layer 120 is coated with an n-type layer 130 of zinc oxide (II) ZnO, having a thickness from 100nm to 2000nm, in a form of nano-rods, wherein the empty spaces between the nano-rods are filled with zinc oxide (II) ZnO or magnesium oxide (II) doped zinc oxide (II) (ZnO:MgO). Alternatively, the p-type layer 120 can be coated with the n-type layer 130 of magnesium oxide (II) doped zinc oxide (II) (ZnO:MgO). In that case, the n-type layer 130 has a thickness from 100nm to 2000µm. The n-type layer 130 can be manufactured using an ALD method (Atomic Layer Deposition) or a PECVD method (Plasma-enhanced Chemical Vapour Deposition).

On the n-type layer 130, there is located an aluminum doped zinc oxide (II) (AZO) transparent layer 140 that acts as a transparent electric contact.

In the first embodiment, individual layers 120-140 of the active area, that are placed on the opposite sides of the baseplate 110, are connected with each other through perforation openings 160 (which are located on the inside walls of the openings). In other words, applying subsequent layers 120-140 gradually limits the clearance of the openings 160, which remain open in a final product.

On the transparent layer 140, there are formed metallic electric contacts 150 based on copper Cu and/or silver Ag particles and nano-particles. The electric contacts 150 act as a negative electrode and can be applied by screen-printing, stencil printing or ink-jet printing and their deposition is realized using low-temperature heating techniques (up to 300°C).

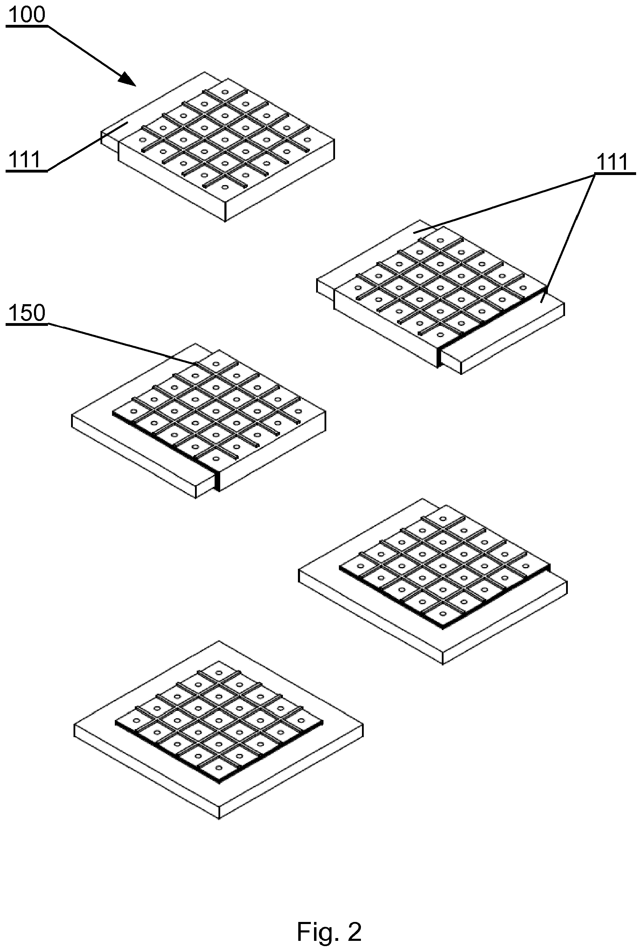

Fig. 2 presents individual variants of the first embodiment of a photovoltaic cell 100. In a first variant, a base contact 111 of the baseplate 110 is located only on a single edge of the solar cell 100. In a second variant, the baseplate 110 has two base contacts 111, located on opposite or adjacent edges of the solar cell 100. In a third variant, the baseplate 110 comprises three base contacts 111 located on three edges of the solar cell. In turn, in a fourth variant, the baseplate 110 has four base contacts 111, located on every edge of the solar cell.

The baseplate 110, which acts as a positive electrode, is connected to the p-type area, whereas the negative electrode (the metallic electric contacts 150) is connected to the transparent layer 140 formed on the surface of the n-type semiconductor, that is on the n-type layer 130. Therefore, it is possible to connect the photovoltaic cell 100 to a receiver, or to join solar cells into photovoltaic modules in order to increase their total generated voltage or current.

In the first embodiment, the photovoltaic cell 100 comprises a single-semiconductor junction located on both sides of the baseplate, passing through the perforation openings 160 in the baseplate.

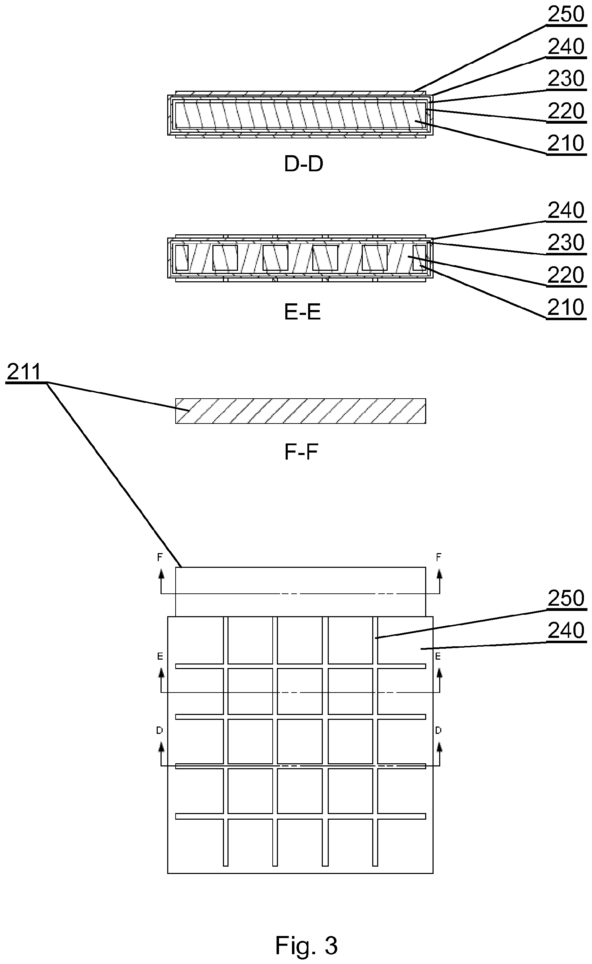

Fig. 3 presents a first variant of a second embodiment of a non-silicon photovoltaic cell in a top view and cross-sections D-D, E-E and F-F. The photovoltaic cell 200 consists of a baseplate 210, which acts as a positive electrode, wherein the baseplate 210 is coated with a copper layer or is entirely made of copper. Preferably, the baseplate 210 has a thickness from 0.02mm to 2mm. The baseplate 210 comprises a base contact area (a base electric contact area) 211 and a multilayered semiconductor structure which forms a p-n junction or two p-n junctions having a common p-type element applied onto the residual surface active area. An active area is located on both sides of the baseplate 210. The active area of the baseplate 210 is perforated, wherein perforation openings 260 have a diameter between 0.02mm to 2mm and can have a cylindrical, elliptic, oval, elongated, polygonal or irregular cross-section. A distance between the perforation openings 260 is from 0.02mm to 2mm, wherein the openings 260 can be distributed in a pattern selected from the group consisting of a square pattern, a staggered pattern, a diagonal pattern, a z-staggered pattern, a periodically changing pattern or an irregular pattern, as shown in Fig. 5.

The baseplate 210, in the region of the active area, is coated with a p-type layer 220 of copper oxide (II) CuO or copper oxide (I) Cu₂O having a thickness from 100nm to 2000µm. The p-type layer 220 can be manufactured using an ALD method (Atomic Layer Deposition), a PECVD method (Plasma-enhanced Chemical Vapour Deposition), a thermal method using heated chamber in an oxygen atmosphere or by electrolytic oxidation.

In a second embodinent, the p-type layer 220 penetrates into the perforation openings 260, thereby connecting both sides of the baseplate 210, and entirely covering the openings 260.

The p-type layer 220 is coated with an n-type layer made of zinc oxide (II) ZnO, having a thickness from 100nm to 2000nm, in a form of nano-rods, wherein the empty spaces between the nano-rods are filled with a zinc oxide (II) ZnO structure or magnesium oxide (II) doped zinc oxide (II) (ZnO:MgO). Alternatively, the p-type layer 220 is coated with an n-type layer 230 of magnesium oxide doped (II) zinc oxide (II) (ZnO:MgO). Then, the n-type layer 230 has a thickness from 100nm to 2000µm. The layer 230 can be manufactured using an ALD method (Atomic Layer Deposition) or a PECVD method (Plasma Enhanced Chemical Vapour Deposition).

On the n-type layer 230, an aluminum doped zinc oxide (II) (AZO) transparent layer 240 is located, acting as a transparent electric contact.

On the transparent layer 240 there are formed metallic electric contacts 250 based on copper Cu and/or silver Ag particles and nano-particles. The electric contacts 250 act as a negative electrode and can be applied by screen-printing, stencil printing or ink-jet printing and their deposition is realized using low-temperature heating techniques (up to 300°C).

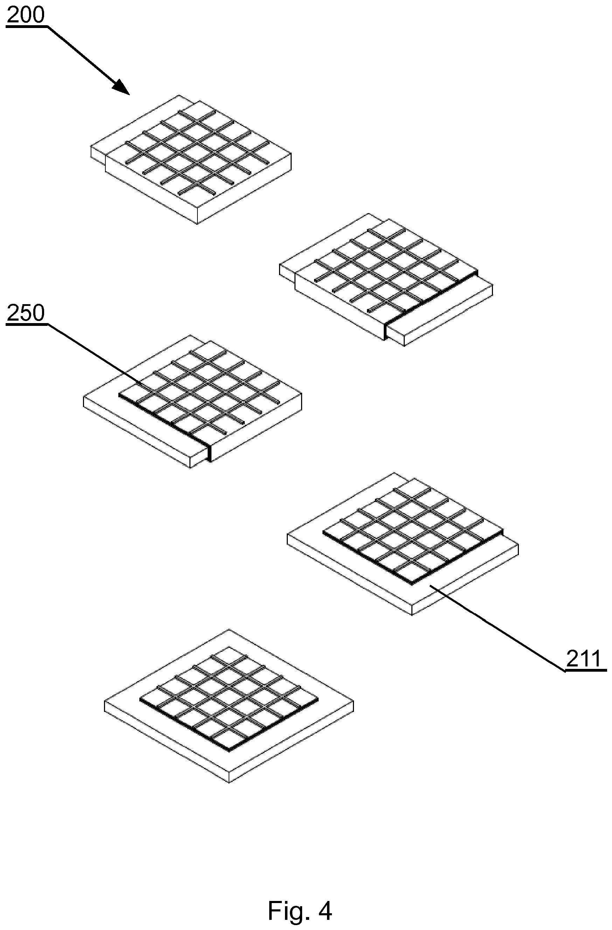

Fig. 4 presents particular variants of the second embodiment of the photovoltaic cell 200. In a first variant, the base contact 211 of the baseplate 210 is located only on a single edge of the solar cell 200. In a second variant, the baseplate 210 has two base contacts 211, located on opposite or adjacent edges of the solar cell 200. In a third variant, the baseplate 200 comprises three base contacts 211 located on three edges of the solar cell. In turn, in the fourth variant, the baseplate 210 has four base contacts 211, located on every edge of the solar cell.

The baseplate 210, which acts as the positive electrode, is connected to the p-type area, whereas the negative electrode is connected to the transparent layer 240 formed on the surface of the n-type semiconductor (the n-type layer 230). Due to that, it is possible to connect the photovoltaic cell 200 to a receiver, or to join solar cells into photovoltaic modules in order to increase their total generated voltage or current.

In the second embodiment, the photovoltaic cell 200 comprises two separate semiconductor junctions, on both sides of the baseplate, having a common positive electrode and a common p-type element.

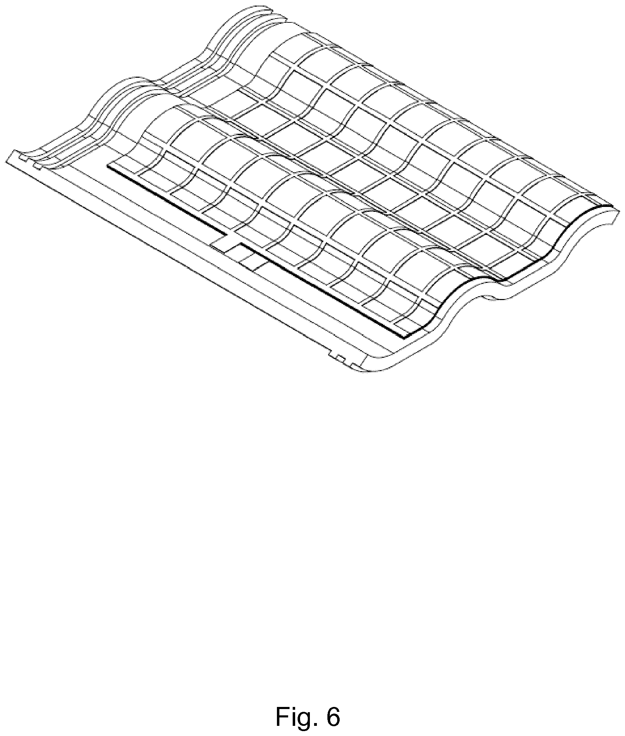

Fig. 6 presents an example of a photovoltaic cell applied onto an irregular surface of a roof tile. Unlike silicon solar cells, which are limited by a size of a silicon wafer, the photovoltaic cells 100, 200 according to the presented solution can be manufactured in various sizes. Furthermore, due to the fact that the baseplate 110, 210 is made of copper or is coated with copper, the photovoltaic cell can have any shape (round, cylindrical, irregular), it may also be flexible and/or foldable. For example, the photovoltaic cell 100, 200 can be in the form of a foil, which can be integrated with construction elements, such as roof tiles, sheet steel tiles, bricks. The photovoltaic cell 100, 200 can be manufactured directly on the surface of the photovoltaic materials, that allows to integrate the solar cells directly with a building facade.

The photovoltaic cells 100, 200 can be manufactured in typical sizes (156x156mm, 200x200mm) and connected together into modules which form photovoltaic panels, which are usable for domestic or industrial generation of electrical energy.

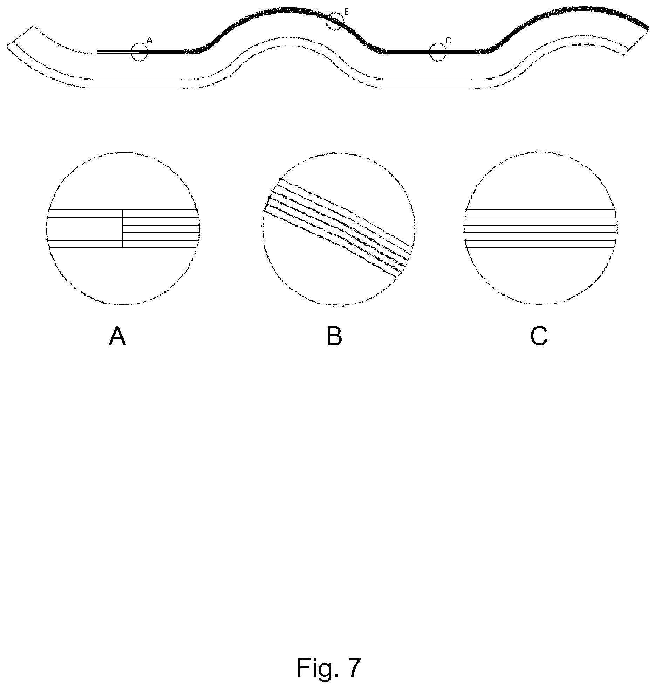

Fig. 7 presents a roof tile of Fig. 6 in a side view and details of A, B and C areas. The photovoltaic cell 100, 200 is in a form of a flexible foil that adapts to a curvature of a roof tile surface. The details of A, B and C areas show the arrangement of individual layers of the solar cell applied on the irregular surface of a roof tile.

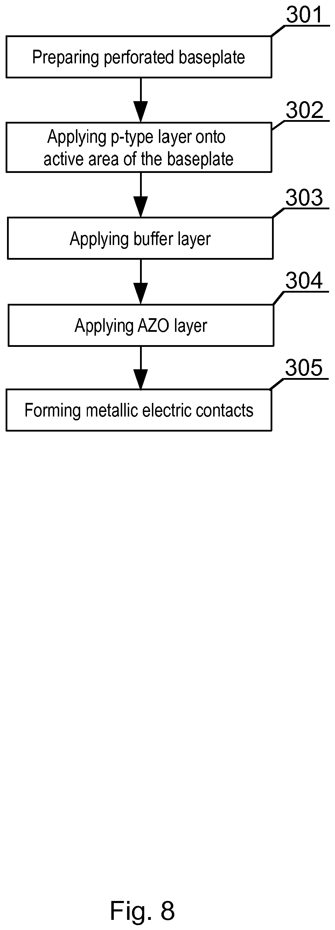

Fig. 8 presents steps of a method of manufacturing of a photovoltaic cell. In a first step 301, a perforated baseplate is prepared. For example, the method may comprise cutting out the baseplate form a copper or aluminum sheet (or a metal sheet coated with copper or aluminum) to obtain a desired shape and punching the openings in a perforation process on the active area of the plate. Subsequently, in step 302, a p-type layer of copper oxide (II) CuO or copper oxide (I) Cu₂O is applied onto the active area of the baseplate, using an ALD method (Atomic Layer Deposition), a PECVD method (Plasma-Enhanced Chemical Vapor Deposition), a thermal method using a heated chamber in an oxygen atmosphere or by oxidation; or a p-type layer of tin sulfide SnS is formed on the active area of baseplate, using an ALD method (Atomic Layer Deposition), a PECVD method (Plasma-Enhanced Chemical Vapor Deposition), a hydrothermal method, a CBD (Chemical Bath Deposition) or an electrolytic method. In step 303, the n-type layer is applied onto the p-type layer using an ALD method (Atomic Layer Deposition) or a PECVD method (Plasma-Enhanced Chemical Vapor Deposition). In the next step 304, a transparent layer of aluminum doped zinc oxide (II) is applied onto the n-type layer in the ALD or PECVD process. In the last step 305, metallic electric contacts are printed onto the transparent layer by screen-printing, stencil printing or ink-jet printing and their deposition is realized using low-temperature heating techniques (up to 300°C).

The presented method of manufacturing the photovoltaic cells allows to eliminate silicon from the process of their production and, as a consequence, manufacturing non-silicon photovoltaic cells. As a result, the step of manufacturing the monolayer was eliminated, and also wet chemical processes were eliminated (such as the texturization of the solar cells or etching glazes that were formed during the diffusion process).

At the same time, it is possible to manufacture a double-sided elastic photovoltaic cell having one or multiple junctions (electric base contacts). The geometry of the photovoltaic cells can be freely selected according to their supposed use, e.g. integration with a roofing or a facade.

## Claims

1. A photovoltaic cell (100, 200) comprising a baseplate (110, 210) with a coating, having a perforated active area located on both sides of the baseplate and an electric contact area located on at least one edge of the baseplate, the solar cell being **characterized in that**, on the active area there are located successively the following layers arranged on each other:
- a p-type layer (120, 220) having a thickness from 100nm to 2000 µm;
- an n-type layer (130, 230) having a thickness from 100nm to 2000µm, made of magnesium oxide (II) doped zinc oxide (II) (ZnO:MgO);
- a transparent layer (140, 240) made of aluminum doped zinc oxide (II), that forms a transparent electric contact;
- a metallic electric contacts layer (150, 250);
- wherein either the p-type layer (120),
the n-type layer (130) and the transparent layer (140) disposed on the opposite sides of the baseplate (110) are connected together via perforation openings (160), or the p-type layer (220) is located in the entire volume of the perforation openings (260) and the other layers (230, 240) located on the opposite sides of the baseplate (210) are not connected with each other.

2. The photovoltaic cell according to claim 1, **characterized in that** the n-type layer (130, 230) is made of zinc oxide (II) having a thickness from 100nm to 2000nm and has a form of nano-rods, wherein empty spaces between the nano-rods are filled with a magnesium oxide (II) doped zinc oxide (II) (ZnO:MgO) structure.

3. The photovoltaic cell according to any of claims 1-2, **characterized in that** the n-type layer (130, 230) is made of zinc oxide (II) having a thickness from 100nm to 2000nm and has a form of nano-rods, wherein empty spaces between the nano-rods are filled with a zinc oxide (II) structure.

4. The photovoltaic cell according to any of the preceding claims, **characterized in that** the perforation openings (160, 260) have a shape selected from the group comprising a cylindrical, elliptic, oval, elongated, polygonal, irregular shape.

5. The photovoltaic cell according to any of the preceding claims, **characterized in that** the perforation openings (160, 260) are distributed in a pattern selected from the group comprising a square pattern, a staggered pattern, a diagonal pattern, a z-staggered pattern, a periodically changing pattern, an irregular pattern.

6. The photovoltaic cell according to any of the preceding claims, **characterized in that**, when the layers (120-140) disposed on the opposite sides of the baseplate (110) are connected together via perforation openings, the empty spaces inside the perforation openings (160) are filled with a light-scattering medium.

7. The photovoltaic cell according to any of the preceding claims, **characterized in that** it is coupled with a reflecting, light scattering surface.

8. A construction element **characterized in that** the photovoltaic cell (100, 200) according to any of claims 1-7 in a form of a foil is applied on a surface of the construction element.

9. The construction element according to claim 8, **characterized in that** the photovoltaic cell (100, 200) is integrated with the surface of the construction element.

10. A method of manufacturing of a photovoltaic cell according to claim 1 **characterized in that** it comprises the following steps:
- preparing (301) a baseplate (110, 210) having a perforated active area
- applying (302) a p-type layer (120, 220) onto the active area of the baseplate using an ALD method (Atomic Layer Deposition);
- applying (303) an n-type layer (130, 230) onto the p-type layer using an ALD method (Atomic Layer Deposition);
- applying (304) a transparent layer (140, 240) of zinc oxide (II) doped with aluminum onto the n-type layer using an ALD method (Atomic Layer Deposition); and
- printing (305) metallic electric contacts (150, 250) on the transparent layer by screen printing using low-temperature heating up to 300°C.

11. The method according to claim 10, **characterized in that** the p-type layer is applied by a PECVD method (Plasma-Enhanced Chemical Vapor Deposition).

12. The method according to claim 10, **characterized in that** the p-type layer is applied by a thermal method using a heated chamber in an oxygen atmosphere.

13. The method according to claim 10, **characterized in that** the p-type layer is applied by an electrolytic oxidation method.

14. The method according to any of the claims 10-13, **characterized in that** the n-type layer is applied by a PECVD method (Plasma-Enhanced Chemical Vapor Deposition).

## Patentansprüche

1. Photovoltaikzelle (100, 200), umfassend eine Grundplatte (110, 210) mit einer Beschichtung, die einen perforierten aktiven Bereich, der sich auf beiden Seiten der Grundplatte befindet, und einen elektrischen Kontaktbereich aufweist, der sich an mindestens einer Kante der Grundplatte befindet, wobei die Solarzelle **dadurch gekennzeichnet ist, dass** sich auf dem aktiven Bereich nacheinander die folgenden Schichten befinden, die aufeinander angeordnet sind:
- eine p-Typ-Schicht (120, 220), die eine Dicke von 100 nm bis 2000 µm aufweist;
- eine n-Typ-Schicht (130, 230), die eine Dicke von 100 nm bis 2000 µm aufweist, die aus mit Magnesiumoxid (II) dotiertem Zinkoxid (II) (ZnO:MgO) hergestellt ist;
- eine transparente Schicht (140, 240), die aus mit Aluminium dotiertem Zinkoxid (II) hergestellt ist, die einen transparenten elektrischen Kontakt bildet;
- eine metallische elektrische Kontaktschicht (150, 250);
- wobei entweder die p-Typ-Schicht (120), die n-Typ-Schicht (130) und die transparente Schicht (140), die auf den gegenüberliegenden Seiten der Grundplatte (110) angeordnet sind, über Perforationsöffnungen (160) miteinander verbunden sind, oder sich die p-Typ-Schicht (220) in dem gesamten Volumen der Perforationsöffnungen (260) befindet und die anderen Schichten (230, 240), die sich auf den gegenüberliegenden Seiten der Grundplatte (210) befinden, nicht miteinander verbunden sind.

2. Photovoltaikzelle nach Anspruch 1, **dadurch gekennzeichnet, dass** die n-Typ-Schicht (130, 230) aus Zinkoxid (II) hergestellt ist, das eine Dicke von 100 nm bis 2000 nm aufweist und eine Form von Nanostäben aufweist, wobei leere Räume zwischen den Nanostäben mit einer mit Magnesiumoxid (II) dotierten Zinkoxid-(II)-(ZnO:MgO)-Struktur gefüllt sind.

3. Photovoltaikzelle nach einem der Ansprüche 1-2, **dadurch gekennzeichnet, dass** die n-Typ-Schicht (130, 230) aus Zinkoxid (II) hergestellt ist, das eine Dicke von 100 nm bis 2000 nm aufweist und eine Form von Nanostäben aufweist, wobei leere Räume zwischen den Nanostäben mit einer Zinkoxid-(II)-Struktur gefüllt sind.

4. Photovoltaikzelle nach einem der vorhergehenden Ansprüche, **dadurch gekennzeichnet, dass** die Perforationsöffnungen (160, 260) eine Form aufweisen, die aus der Gruppe ausgewählt ist, die eine zylindrische, elliptische, ovale, längliche, polygonale, unregelmäßige Form umfasst.

5. Photovoltaikzelle nach einem der vorhergehenden Ansprüche, **dadurch gekennzeichnet, dass** die Perforationsöffnungen (160, 260) in einem Muster verteilt sind, das aus der Gruppe ausgewählt ist, die ein quadratisches Muster, ein versetztes Muster, ein diagonales Muster, ein z-versetztes Muster, ein sich periodisch änderndes Muster, ein unregelmäßiges Muster umfasst.

6. Photovoltaikzelle nach einem der vorhergehenden Ansprüche, **dadurch gekennzeichnet, dass**, wenn die Schichten (120-140), die auf den gegenüberliegenden Seiten der Grundplatte (110) angeordnet sind, über Perforationsöffnungen miteinander verbunden sind, die leeren Räume innerhalb der Perforationsöffnungen (160) mit einem Lichtstreumedium gefüllt sind.

7. Photovoltaikzelle nach einem der vorhergehenden Ansprüche, **dadurch gekennzeichnet, dass** sie mit einer reflektierenden, lichtstreuenden Oberfläche gekoppelt ist.

8. Konstruktionselement, das **dadurch gekennzeichnet ist, dass** die Photovoltaikzelle (100, 200) nach einem der Ansprüche 1-7 in einer Form einer Folie auf eine Oberfläche des Konstruktionselements aufgebracht ist.

9. Konstruktionselement nach Anspruch 8, **dadurch gekennzeichnet, dass** die Photovoltaikzelle (100, 200) in die Oberfläche des Konstruktionselements integriert ist.

10. Verfahren zur Herstellung einer Photovoltaikzelle nach Anspruch 1, **dadurch gekennzeichnet, dass** es die folgenden Schritte umfasst:
- Vorbereiten (301) einer Grundplatte (110, 210), die einen perforierten aktiven Bereich aufweist:
- Aufbringen (302) einer p-Typ-Schicht (120, 220) auf den aktiven Bereich der Grundplatte unter Anwendung eines ALD-Verfahrens (Atomschichtabscheidung);
- Aufbringen (303) einer n-Typ-Schicht (130, 230) auf die p-Typ-Schicht unter Anwendung eines ALD-Verfahrens (Atomschichtabscheidung);
- Aufbringen (304) einer transparenten Schicht (140, 240) aus Zinkoxid (II) dotiert mit Aluminium auf die n-Typ-Schicht unter Anwendung eines ALD-Verfahrens (Atomschichtabscheidung); und
- Drucken (305) von metallischen elektrischen Kontakten (150, 250) auf die transparente Schicht durch Siebdrucken unter Anwendung von Niedertemperaturerwärmung auf 300 °C.

11. Verfahren nach Anspruch 10, **dadurch gekennzeichnet, dass** die p-Typ-Schicht durch ein PECVD-Verfahren (plasmaunterstützte chemische Dampfabscheidung) aufgebracht wird.

12. Verfahren nach Anspruch 10, **dadurch gekennzeichnet, dass** die p-Typ-Schicht durch ein thermisches Verfahren unter Verwendung einer beheizten Kammer in einer Sauerstoffatmosphäre aufgebracht wird.

13. Verfahren nach Anspruch 10, **dadurch gekennzeichnet, dass** die p-Typ-Schicht durch ein elektrolytisches Oxidationsverfahren aufgebracht wird.

14. Verfahren nach einem der Ansprüche 10-13, **dadurch gekennzeichnet, dass** die n-Typ-Schicht durch ein PECVD-Verfahren (plasmaunterstützte chemische Dampfabscheidung) aufgebracht wird.

## Revendications

1. Cellule photovoltaïque (100, 200) comprenant une plaque de base (110, 210) avec un revêtement, ayant une zone active perforée située sur les deux côtés de la plaque de base et une zone de contact électrique située sur au moins un bord de la plaque de base, la cellule solaire étant **caractérisée en ce que**, sur la zone active, les couches suivantes sont situées successivement, agencées les unes sur les autres :
- une couche de type p (120, 220) ayant une épaisseur de 100 nm à 2 000 µm ;
- une couche de type n (130, 230) ayant une épaisseur de 100 nm à 2 000 µm, fabriquée en oxyde de zinc (II) dopé à l'oxyde de magnésium (II) (ZnO : MgO) ;
- une couche transparente (140, 240) fabriquée en oxyde de zinc (II) dopé à l'aluminium, qui forme un contact électrique transparent ;
- une couche de contacts électriques métalliques (150, 250) ;
- dans laquelle soit la couche de type p (120), la couche de type n (130) et la couche transparente (140) disposées sur les côtés opposés de la plaque de base (110) sont connectées ensemble par le biais d'ouvertures de perforation (160), soit la couche de type p (220) est située dans le volume entier des ouvertures de perforation (260) et les autres couches (230, 240) situées sur les côtés opposés de la plaque de base (210) ne sont pas connectées l'une à l'autre.

2. Cellule photovoltaïque selon la revendication 1, **caractérisée en ce que** la couche de type n (130, 230) est fabriquée en oxyde de zinc (II) ayant une épaisseur de 100 nm à 2 000 nm et a une forme de nanotiges, dans laquelle des espaces libres entre les nanotiges sont remplis avec une structure d'oxyde de zinc (II) dopé à l'oxyde de magnésium (II) (ZnO : MgO).

3. Cellule photovoltaïque selon l'une quelconque des revendications 1 à 2, **caractérisée en ce que** la couche de type n (130, 230) est fabriquée en oxyde de zinc (II) ayant une épaisseur de 100 nm à 2 000 nm et a une forme de nanotiges, dans laquelle des espaces libres entre les nanotiges sont remplis avec une structure d'oxyde de zinc (II).

4. Cellule photovoltaïque selon l'une quelconque des revendications précédentes, **caractérisée en ce que** les ouvertures de perforation (160, 260) ont une forme choisie parmi le groupe comprenant une forme cylindrique, elliptique, ovale, allongée, polygonale, irrégulière.

5. Cellule photovoltaïque selon l'une quelconque des revendications précédentes, **caractérisée en ce que** les ouvertures de perforation (160, 260) sont réparties selon un motif choisi parmi le groupe comprenant un motif carré, un motif en quinconce, un motif en diagonale, un motif en quinconce en z, un motif à variations périodiques, un motif irrégulier.

6. Cellule photovoltaïque selon l'une quelconque des revendications précédentes, **caractérisée en ce que**, quand les couches (120-140) disposées sur les côtés opposés de la plaque de base (110) sont connectées ensemble par le biais d'ouvertures de perforation, les espaces libres à l'intérieur des ouvertures de perforation (160) sont remplis avec un support de diffusion de lumière.

7. Cellule photovoltaïque selon l'une quelconque des revendications précédentes, **caractérisée en ce qu'**elle est couplée avec une surface de diffusion de lumière, réfléchissante.

8. Élément de construction **caractérisé en ce que** la cellule photovoltaïque (100, 200) selon l'une quelconque des revendications 1 à 7 sous une forme de feuille est appliquée sur une surface de l'élément de construction.

9. Élément de construction selon la revendication 8, **caractérisé en ce que** la cellule photovoltaïque (100, 200) est d'un seul tenant avec la surface de l'élément de construction.

10. Procédé de fabrication d'une cellule photovoltaïque selon la revendication 1 **caractérisé en ce qu'**il comprend les étapes suivantes :
- préparation (301) d'une plaque de base (110, 210) ayant une zone active perforée ;
- application (302) d'une couche de type p (120, 220) sur la zone active de la plaque de base en utilisant un procédé ALD (dépôt de couches atomiques) ;
- application (303) d'une couche de type n (130, 230) sur la couche de type p en utilisant un procédé ALD (dépôt de couches atomiques) ;
- application (304) d'une couche transparente (140, 240) d'oxyde de zinc (II) dopé avec de l'aluminium sur la couche de type n en utilisant un procédé ALD (dépôt de couches atomiques) ; et
- impression (305) de contacts électriques métalliques (150, 250) sur la couche transparente par impression sérigraphique en utilisant un chauffage à basse température allant jusqu'à 300 °C.

11. Procédé selon la revendication 10, **caractérisé en ce que** la couche de type p est appliquée par un procédé PECVD (dépôt chimique en phase vapeur assisté par plasma).

12. Procédé selon la revendication 10, **caractérisé en ce que** la couche de type p est appliquée par un procédé thermique en utilisant une chambre chauffée sous atmosphère d'oxygène.

13. Procédé selon la revendication 10, **caractérisé en ce que** la couche de type p est appliquée par un procédé d'oxydation électrolytique.

14. Procédé selon l'une quelconque des revendications 10 à 13, **caractérisé en ce que** la couche de type n est appliquée par un procédé PECVD (dépôt chimique en phase vapeur assisté par plasma).
